# EUROPEAN PATENT SPECIFICATION

(11) **EP 2 656 385 B1**
(45) Date of publication and mention of the grant of the patent: **26.05.2021**
(21) Application number: 10861039.5
(22) Date of filing: 20.12.2010
(51) Int. Cl.: H01L 25/18, H01L 25/16, H04B 1/44, H04B 1/08, H01F 17/00, H01L 23/66, H01L 23/64, H01L 23/00, H01L 23/522, H01L 23/498, H01L 49/02

(54) **INTEGRATED DIGITAL- AND RADIO-FREQUENCY SYSTEM-ON-CHIP DEVICES WITH INTEGRAL PASSIVE DEVICES IN PACKAGE SUBSTRATES**
INTEGRIERTE DIGITAL- UND RADIOFREQUENZ-SOC-VORRICHTUNGEN MIT INTEGRIERTEN PASSIVEN BAUELEMENTEN IN GEHÄUSESUBSTRATEN
DISPOSITIFS PUCE-SYSTÈME À RADIOFRÉQUENCES ET NUMÉRIQUES INTÉGRÉS, AVEC DISPOSITIFS PASSIFS INTÉGRÉS, DANS DES SUBSTRATS DE BOÎTIER

(43) Date of publication of application: 30.10.2013
(73) Proprietor: Intel Corporation, Santa Clara, CA 95054 (US)
(72) Inventor: KAMGAING, Telesphor, Chandler, Arizona 85249 (US); RAO, Valluri, Saratoga, California 95070 (US)
(74) Representative: Rummler, Felix
(86) International application number: PCT/US2010/061388
(87) International publication number: WO 2012/087287

(56) References cited:
- US-A1- 2003 001 709
- US-A1- 2003 112 576
- US-A1- 2004 145 874
- US-A1- 2005 194 673
- US-A1- 2005 245 001
- US-A1- 2007 158 787
- US-A1- 2007 251 719
- US-A1- 2008 001 698
- US-A1- 2009 284 339
- US-A1- 2010 078 779
- US-A1- 2010 225 400

## Description

Disclosed embodiments relate to integrated digital- and radio-frequency devices that include passive devices that are disposed in package substrates.

### Background Art

From US 2010/225400 A1 a system-on-chip electronic device is known, wherein said device includes a digital processor and radio-frequency integrated-circuit DP-RFIC device on a semiconductive substrate mounted on a package substrate. An inductor which is integral to the package substrate is coupled to said DP-RFIC device, wherein said inductor is formed as a single loop that includes six via stack structures which are seriatim coupled, wherein said six via stacks are connected by respective five coil segments which are integral with the package substrate.

### BRIEF DESCRIPTION OF THE DRAWINGS

In order to understand the manner in which embodiments are obtained, a more particular description of various embodiments briefly described above will be rendered by reference to the appended drawings. These drawings depict embodiments that are not necessarily drawn to scale and are not to be considered to be limiting in scope. Some embodiments will be described and explained with additional specificity and detail through the use of the accompanying drawings in which:
FIG. 1 is a cross-section elevation of a chip apparatus according to an example useful for understanding the invention;
FIG. 2 is a cross-section elevation of a chip apparatus according to an example useful for understanding the invention;
FIG. 3 is a cross-section elevation of a chip apparatus according to an example useful for understanding the invention;
FIG. 4 is a cross-section elevation of a chip apparatus according to an example useful for understanding the invention;
FIG. 5 is a cross-section elevation of a chip apparatus according to an example useful for understanding the invention;
FIG. 6 is a cross-section elevation of a chip apparatus according to an example useful for understanding the invention;
FIG. 7 is a cross-section elevation of a chip apparatus according to an example useful for understanding the invention;
FIG. 8 is a perspective elevation wireframe of a bump inductor according to an example useful for understanding the invention;
FIG. 8a is a side elevation detail of the bump inductor depicted in FIG. 8 according to an example useful for understanding the invention;
FIG. 8b is a side elevation detail of the bump inductor depicted in FIG. 8 according to an example useful for understanding the invention;
FIG. 9 is a perspective elevation wireframe of a bump inductor according to an example useful for understanding the invention;
FIG. 10 is a perspective elevation wireframe of a stacked-via inductor according to an example useful for understanding the invention;
FIG. 11 is a perspective elevation wireframe of a composite bump-and-stacked-via inductor according to an example embodiment;
FIG. 12 is a perspective elevation of a transformer according to an example useful for understanding the invention;
FIG. 13 is a perspective elevation of an inductor according to an example useful for understanding the invention;
FIG. 14 is a perspective elevation of an inductor according to an example useful for understanding the invention;
FIG. 15 is a perspective elevation of a transformer according to an example useful for understanding the invention;
FIG. 16 is a top plan of an on-package balun that uses planar transformer examples set forth in this disclosure;
FIG. 17 is a circuit diagram of the three-capacitor, one-transformer device depicted in FIG. 16;
FIG. 18 is a top plan of a four-layer linear or circular inductor according to an example useful for understanding the invention;
FIGs. 18a, 18b, 18c, and 18d show assembly of the transformer depicted in FIG. 18;
FIG. 19 is a wire-frame exploded perspective of a semiconductor package that uses a hybrid SoC and integral coils in a package substrate according to an example useful for understanding the invention;
FIG. 20 is a circuit diagram of the four-capacitor, four-inductor device depicted in FIG. 19;
FIG. 21 is a top plan of a semiconductor package that uses a hybrid SoC and integral coils in a mounting substrate according to an example useful for understanding the invention;
FIG. 22 is a process and method flow diagram according to an example useful for understanding the invention; and
FIG. 23 is a schematic of a computing/communication system according to an example useful for understanding the invention.

### SUMMARY

The invention is defined in the claims. In the following description, any embodiment referred to and not falling within the scope of the claims is merely an example useful to the understanding of the invention.

### DETAILED DESCRIPTION

Processes are disclosed where hybrid chip embodiments include digital processor (DP) and radio-frequency integrated circuit (RFIC) functionalities on a hybrid semiconductive substrate. As such, a system on chip (SoC) includes the hybrid DP-RFIC chip that is disposed on a package substrate. Passive devices that support the RFIC are coupled to the RFIC but are disposed on or in the package substrate. The passive devices include inductors and transformers that are metal structures fabricated as bump inductors or metal inductors and transformers that are integral to the package substrate.

Reference will now be made to the drawings wherein like structures may be provided with like suffix reference designations. In order to show the structures of various examples and the embodiment more clearly, the drawings included herein are diagrammatic representations of integrated circuit structures. Thus, the actual appearance of the fabricated integrated circuit structures, for example in a photomicrograph, may appear different while still incorporating the claimed structures of the illustrated embodiment. Moreover, the drawings may only show the structures useful to understand the illustrated embodiments. Additional structures known in the art may not have been included to maintain the clarity of the drawings.

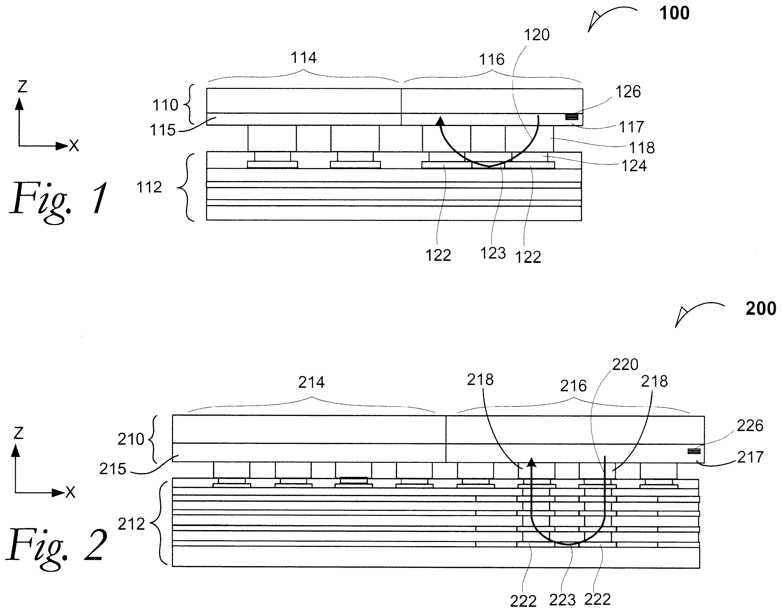

FIG. 1 is a cross-section elevation of a chip apparatus 100 according to an example useful for understanding the invention. A system-on-chip (SoC) 110 includes a DP-RFIC hybrid device 110 that is disposed on a package substrate 112. The DP-RFIC hybrid device 110 includes a digital processor section 114 and an RFIC section 116. In an example, the SoC 110 includes the DP-RFIC hybrid plus a graphics section. Consequently, this SoC 110 example may be referred to as a DP-G-RIRC hybrid 110. Hereinafter, the SoC examples disclosed may be DP-RFIC hybrids or DP-G-RFIC hybrids.

The chip apparatus 100 is depicted in simplified form that includes DP active devices and backend metallization 115 that supports the DP section 114 and RFIC active and passive devices and metallization 117 that supports the RFIC section 116. In an example, the package substrate 112 is a coreless substrate 112. Electrical communication between the DP-RFIC device 110 and the package substrate 112 is carried out through electrical bumps, one of which is referenced with numeral 118. As illustrated, the DP-RFIC 110 is a flip-chip 110 that has been disposed on the package substrate 112 by use of the electrical bumps 118.

In an example, front-end module RF passive devices are deployed between the RFIC 116 and the package substrate 112. As illustrated, an inductor is formed from two electrical bumps 118, two metal pads 122, two -conductive joints 124 that connect the electrical bumps 118 and the metal pads, and a trace 123 between the two metal pads 122. The inductor as a single portion of a loop may also be referred to as a coil and this example may also be referred to as a vertical inductor. Inductive current flow 120 in the inductor is illustrated by a directional arrow that bears the reference number 120. The inductive current flow 120 is therefore coupled to the RFIC 116 through the package substrate 112 where it is restricted to electrical bump connectors 118 that are between the DP-RFIC hybrid device 110 and the package substrate 112. An RF-quality capacitor 126 is depicted conceptually within the silicon of the RFIC 116 according to an example. As a consequence of this example, a front-end module passive device, the vertical inductor 120, is separated out of the silicon of the RFIC 116, to leave more room for active devices. Additionally, partitioning the larger inductors away from the RFIC 116 facilitates reduction of chip size. Also electrical performance may be improved. Also, partitioning the larger inductors enables RF circuits to operate on low resistivity silicon substrates.

As a front-end module passive device, the RF-quality capacitor 126, remains within the silicon of the RFIC 116 where it may be fabricated with a high-dielectric-constant (high-k) material for a useful capacitance and a useful small size compared to that of the vertical inductor. In an example, the capacitor 126 is a diode. In this example, a distributed RF architecture is achieved by partitioning of RF passive devices where the inductor 120 is removed out of the silicon of the RFIC 116, but capacitors and/or diodes 126 remain in the silicon where they may be fabricated with a high-k dielectric.

It may be appreciated that "silicon" may refer to any useful semiconductive material such as Si, GaAs, InSb, and others, although each may have non-equivalent behavior that is useful for given applications. For example, a semiconductive substrate may exhibit a resistivity in a range from 0.1 milli Ohm - cm to 1000 Ohm - cm and be any useful silicon. In an example, 32 nanometer architecture design rules are used to fabricate the SoC hybrid device 110 such as an SoC processor fabricated by Intel Corporation of Santa Clara, California. In an example, 22 nanometer architecture design rules are used to fabricate the SoC hybrid device 110. Other geometries may be implemented in the disclosed examples including those larger and those smaller. In any event, the distributed RF architecture is formed by interconnecting on-chip RF capacitors with on-package RF inductive components to achieve various useful RF filtering and impedance/power/noise matching as required by a given application. For example, a package-substrate mounted or integral inductor may exhibit a quality factor Q in a range from 10 to 100 in comparison to a range of 5-25 for integrated passive device inductors.

FIG. 2 is a cross-section elevation of a chip apparatus 200 according to an example useful for understanding the invention. An SoC 110 includes a DP-RFIC hybrid device 210 that is disposed on a package substrate 212. The DP-RFIC hybrid device 210 includes a digital processor section 214 and an RFIC section 216. The chip apparatus 200 is depicted in simplified form that includes DP active devices and metallization 215 that supports the DP section 214 and RFIC active and passive devices and metallization 217 that supports the RFIC section 216.

Electrical communication between the DP-RFIC device 210 and the package substrate 212 is carried out through electrical bumps, two of which are referenced with numeral 218. As illustrated, the DP-RFIC 210 is a flip-chip 210 that has been disposed on the package substrate 212 by use of the electrical bumps 218.

In an example, front-end module RF passive devices are deployed between the RFIC 216 and the package substrate 212. As illustrated, an inductor is formed from two via stacks, each of which begins with an electrical bumps 218 and ends (running in the Z direction) with a metal pad 222. A trace 223 between the two metal pads 222 couples the two via stacks. The inductor 220 as a single portion of a loop may also be referred to as a coil. Inductive current flow 220 in the inductor is illustrated by a directional arrow that bears the reference number 220. The inductive current flow 220 is therefore coupled to the RFIC 216 through the package substrate 212 where it is includes the two via stacks. An RF-quality capacitor 226 is depicted conceptually within the silicon of the RFIC 216 according to an example. As a consequence of this example, a front-end module passive device 220 is separated out of and partitioned from the silicon of the RFIC 216, which leaves more room for active devices.

As a front-end module passive device, the RF-quality capacitor 226, remains within the silicon of the RFIC 216 where it may be fabricated with a high k material for a useful capacitance and a useful small size compared to that of the vertical inductor 220. In an example, the capacitor 226 is a diode. In this example, partitioning of RF passive devices has been achieved, where the inductor 220 is removed out of the silicon of the RFIC 216, but capacitors and/or diodes 226 remain in the silicon where they may be fabricated with a high-k dielectric.

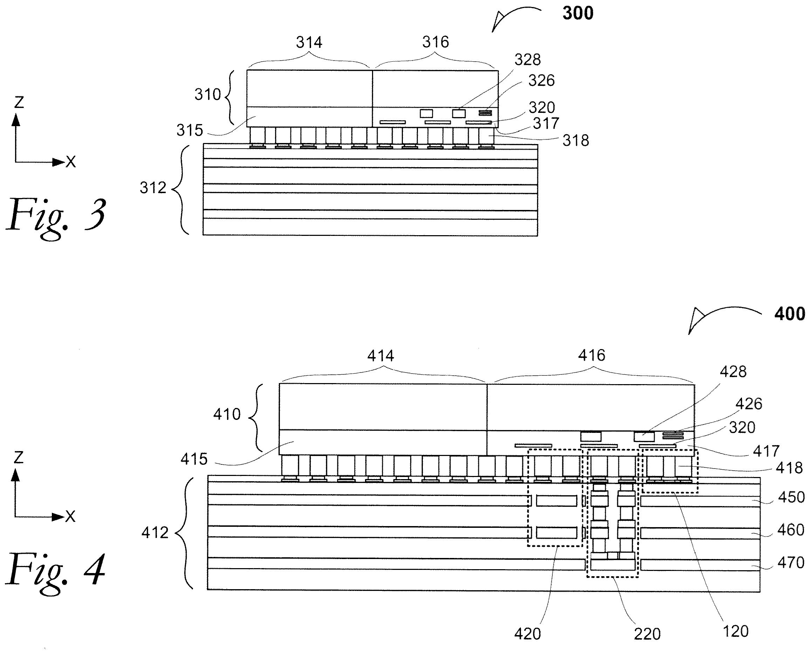

FIG. 3 is a cross-section elevation of a chip apparatus 300 according to an example useful for understanding the invention. An SoC 310 includes a DP-RFIC hybrid device 310 that is disposed on a package substrate 312. The DP-RFIC hybrid device 310 includes a digital processor section 314 and an RFIC section 316. The chip apparatus 300 is depicted in simplified form that includes DP active devices and backend metallization 315 that supports the DP 314 and RFIC active and passive devices and metallization 317 that supports the RFIC 316. In an example, the package substrate 312 is a coreless substrate 312. Electrical communication between the DP-RFIC device 310 and the package substrate 312 is carried out through electrical bumps, one of which is referenced with numeral 318. As illustrated, the DP-RFIC 310 is a flip-chip 310 that has been disposed on the package substrate 312 by use of the electrical bumps 318.

In an example, front-end module RF passive devices are deployed between the RFIC 316 and the package substrate 312. As illustrated, three inductors and/or transformers are depicted with the reference numeral 320 and are intermingled in the metallization 317 of the RFIC 316. In an example, the inductors and/or transformers 320 are fabricated in the silicon of the RFIC 316 along with active devices, one of which is depicted with reference numeral 328. An RF-quality capacitor 326 is depicted conceptually within the silicon of the RFIC 316 according to an example. In an example, the capacitor 326 is a diode. As a consequence of this example, front-end module passive devices, the inductors and/or transformers 320, are separated out of the silicon of the RFIC 316, which leaves more room for active devices therein . Additionally, partitioning the larger inductors away from the RFIC 116 facilitates reduction of chip size. Also electrical performance may be improved. Also, partitioning the larger inductors enables RF circuits to operate on low resistivity silicon substrates. As a front-end module passive device, the RF-quality capacitor 326, remains within the silicon of the RFIC 316 where it may be fabricated with a high- k material for a useful capacitance and a useful small size compared to that of the inductors that may be intermingled within the metallization 317.

FIG. 4 is a cross-section elevation of a chip apparatus 400 according to an example useful for understanding the invention. An SoC 410 includes a DP-RFIC hybrid device 410 that is disposed on a package substrate 412. The DP-RFIC hybrid device 410 includes a digital processor section 414 and an RFIC section 416. The chip apparatus 400 is depicted in simplified form that includes DP active devices and backend metallization 415 that supports the DP 414 and RFIC active and passive devices and metallization 417 that supports the RFIC 416. In an example, the package substrate 412 is a coreless substrate 412. Electrical communication between the DP-RFIC device 410 and the package substrate 412 is carried out through electrical bumps, one of which is referenced with numeral 418. As illustrated, the DP-RFIC 410 is a flip-chip 410 that has been disposed on the package substrate 412 by use of the electrical bumps 418.

In an example, front-end module RF passive devices are deployed between the RFIC 416 and the package substrate 412. As illustrated, four inductors and/or transformers are depicted with the reference numerals 120, 220, 320, and 420, respectively. The vertical inductor 120 is a flip-chip (C4) bump inductor 120 according to examples described and illustrated in FIG. 1. The vertical inductor 220 is a stacked-via inductor 220 according to examples described and illustrated in FIG. 2. The inductors 320 depicted in FIG. 3 are intermingled in the metallization 417 of the RFIC 416 according to an example. In an example, at least one inductor 320 is fabricated in the silicon or in the metallization 417 of the RFIC 416. A vertical planar inductor 420 is depicted conceptually also integral to the package substrate 412. The vertical planar inductor 410 may also be referred to as a three-dimensional (3D) inductor as will be illustrated in subsequent disclosed examples.

The package substrate 412 is depicted as having three levels of metallization including a first level 450, a second level 460, and a subsequent level 470. It may be understood that more than three levels may be present in a given package substrate, whether for the formation of front-end RF passive devices or to support a given hybrid SoC device or both.

Active devices are present in the RFIC section 416, one of which is depicted with reference numeral 428. An RF-quality capacitor 426 is depicted conceptually within the silicon of the RFIC 416 according to an example. In an example, the capacitor 426 is a diode.

As a consequence of this example, front-end module passive devices, the inductors and/or transformers 120, 220, 320, and 420 are partitioned from- and separated out of the silicon of the RFIC 416, which leaves more room for active devices therein. As a front-end module passive device, the RF-quality capacitor 426, remains within the silicon of the RFIC 416 where it may be fabricated with a high- k material for a useful capacitance and a useful small size compared to that of the inductors that may be intermingled within the metallization 417 or deployed integral to the package substrate 412.

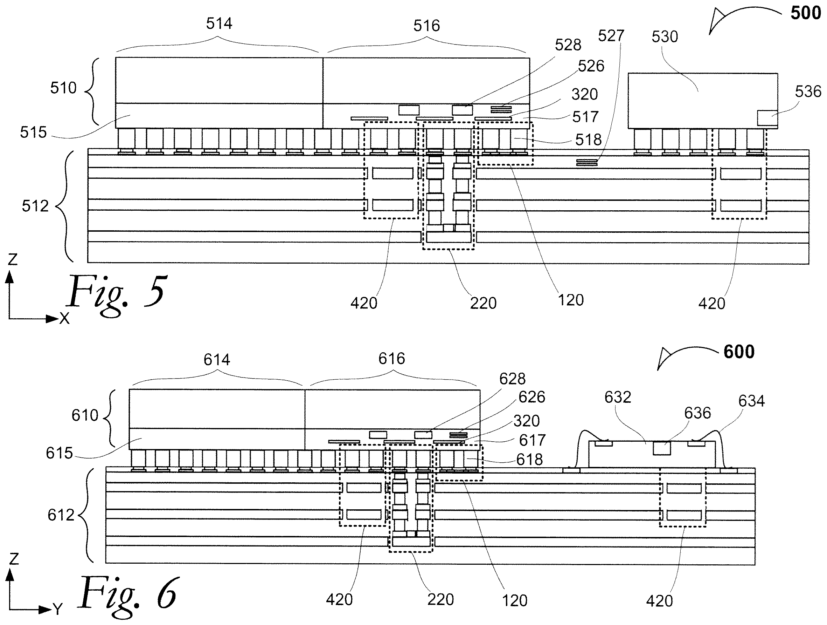

FIG. 5 is a cross-section elevation of a chip apparatus 500 according to an example useful for understanding the invention. This example includes an SoC hybrid chip 510 disposed on a package substrate 512 along with a front-end active-device chip 530 that is also disposed on the multilayer package substrate 512. The two chips 510 and 530 have on-chip RF capacitors 526 and 536, respectively, which can be implemented as metal-insulator-metal (MIM) capacitors or multi-finger capacitors (MFC) using the interlayer dielectric material found on the silicon/GaAs backend. The chip apparatus500 is depicted with on-package inductors and/or transformers 120, 220, 320, and 420 such as bump inductors 120 or by patterning of the metal layers integral to the package substrate 512 to achieve the specific inductance values quality factors that are useful for given SoC RFIC applications.

In an example, the inductors are implemented using a single layer of the package substrate 512. In an example, the inductors are implemented using multiple layers of the package substrate 512. Examples thereof have been disclosed and more examples thereof are set forth further in this disclosure. The dice 510 and 530 are assembled to the package substrate 512 using first level interconnections such as flip-chip bumps 518. In an example, bumpless, build-up layer vias are used for bumpless assembly.

The electrical connections and the inductors on the package substrate 512 as well as those on the silicon 510 and 530 are such that selected inductors and capacitors are employed in one or multiple inductance-capacitance (LC) networks that may be used for signal filtering, signal balancing or impedance matching. In an example, duplicate hybrid circuits are implemented several times and at different locations on the same silicon 510 or on the same package substrate 512 depending on whether RF signals are being received by or being broadcast from a given die 510 and/or 530. In an example, similar but not exact hybrid circuits are implemented several times and at different locations on the same silicon 510 or on the same package substrate 512 depending on whether RF signals are being received by or being broadcast from a given die 510 and/or 530.

In an example, one of such implementations is useful at any interface the chip apparatus 500 experiences with an RF signal. In an example, where the RF front end is implemented in the SoC chip 510 such as at the inductor 320, the RF front-end capacitors 526 are implemented on the SoC chip 510. In an example, limited discrete or chip capacitors 527 are implemented on the package substrate 512 to complement the hybrid LC front-end RF network that supports the RFIC 516. It may now be appreciated that less than all illustrated inductor examples may be implemented in the RF front end functionalities of the chip apparatus 500.

FIG. 6 is a cross-section elevation of a chip apparatus 600 according to an example useful for understanding the invention. Structures similar to that depicted in FIG. 5 are illustrated. Additionally, a wire-bond die 632 is mounted on the package substrate 612 along side an SoC flip chip 610 that includes a DP section 614 and an RFIC section 616.

The chip apparatus 600 is shown in Y-Z orientation in contrast to the X-Z orientation of the chip apparatus 500 depicted in FIG. 5 to illustrate an example that a plan view of the chip apparatus 600 depicted in FIG. 6 may reveal both a C4 active-device chip 530 as well as a wire-bond chip 632 according to an example. It may now be appreciated that less than all illustrated inductor examples may be implemented in the RF front end functionalities of the chip apparatus 600.

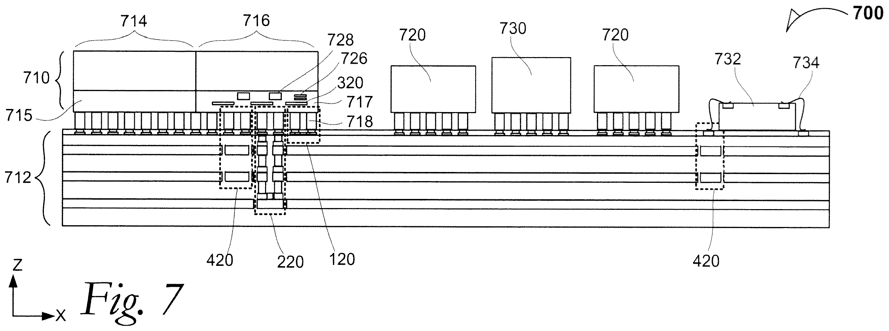

FIG. 7 is a cross-section elevation of a chip apparatus 700 according to an example useful for understanding the invention. This example includes an SoC hybrid chip 710 disposed on a package substrate 712 along with two a front-end active-device chip 730 that is also disposed on the multilayer package substrate 712. Additionally, two silicon-based integrated passive devices (IPDs) 720 are disposed on the package substrate 712. The IPDs 720 may also be glass-based, alumina-based, or low-temperature co-fired ceramic (LTCC) based devices. Additionally in an example, a wire-bond die 732 is mounted on the package substrate 712 along side an SoC flip chip 710 that includes a DP section 714 and an RFIC section 716. In an example, the IPDs 720 provide a medium Q values that are useful for specific implementations. In an example, the IDPs have a Q range from 5 to 25. In an example, any of the inductors 120, 220, 320, and 420 have a Q value in a range from 10 to 100.

The SoC 710 has on-chip RF capacitors 726, which can be implemented as MIM capacitors or MFCs using the interlayer dielectric material found on the silicon/GaAs backend. The package 700 is depicted with on-package inductors and/or transformers 120, 220, 320, 420 such as bump inductors 120 or by patterning of the metal layers integral to the package substrate 712 to achieve the specific inductance values and quality factors that are useful for given applications.

In an example, the inductors are implemented using a single layer of the package substrate 712. In an example, the inductors are implemented using multiple layers of the package substrate 712. Examples thereof have been disclosed and more examples thereof are set forth further in this disclosure. The dice 710 and 730 are assembled to the package substrate 712 using first level interconnections such as flip-chip bumps 718. In an example, bumpless, build-up layer vias are used for bumpless assembly.

The electrical connections and the inductors on the package substrate 712 as well as those on the silicon 710 and 730 are such that selected inductors and capacitors are employed in one or multiple LC networks that may be used for signal filtering, signal balancing or impedance matching. In an example, duplicate hybrid circuits are implemented several times and at different locations on the same silicon 710 or on the same package substrate 712 depending on whether RF signals are being received by or being broadcast from a given die 710 and/or 730. In an example, similar but not exact hybrid circuits are implemented several times and at different locations on the same silicon 710 or on the same package substrate 712 depending on whether RF signals are being received by or being broadcast from a given die 710 and/or 730.

In an example, one of such implementations is useful at any interface the chip apparatus 700 experiences with an RF signal. In an example, where the RF front end is implemented in the SoC chip 710 such as at the inductor 320, the RF front-end capacitors 726 are implemented on the SoC chip 710. In an example, the IPDs 720 are implemented on the package substrate 712 to complement the hybrid LC network. It may now be appreciated that less than all illustrated inductor examples may be implemented in the RF front end functionalities of the chip apparatus 700.

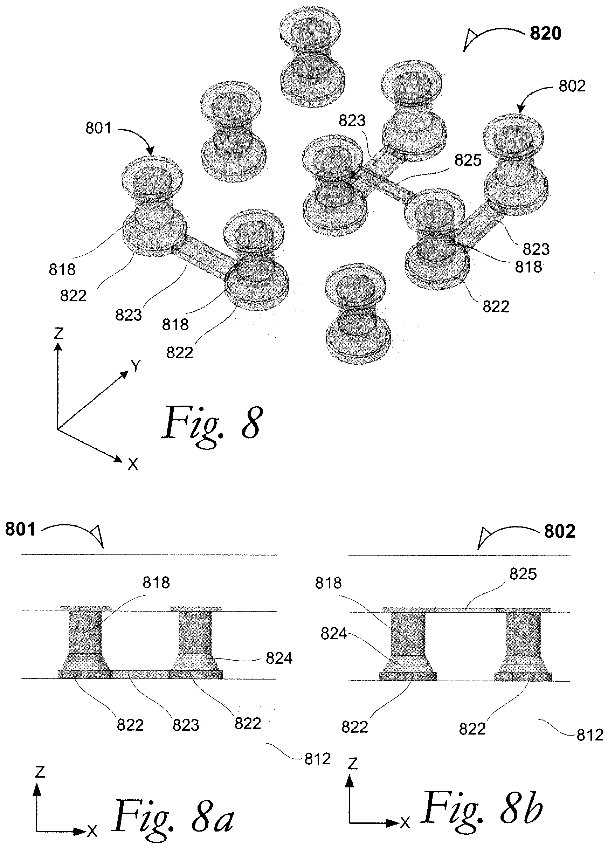

FIG. 8 is a perspective elevation wireframe of two bump inductors 820 according to an example useful for understanding the invention. One bump inductor 801 (FIG. 8a) is formed from two electrical bumps 818, two metal pads 822, two conductive joints 824 that connect the electrical bumps 818 and the metal pads 822, and a bottom trace 823 between the two metal pads 822. One bump inductor 802 (FIG. 8b) is formed from four electrical bumps, four metal pads, four conductive joints that connect the electrical bumps and the metal pads, two bottom traces 823 between two metal pads, and a top trace 825. The inductor 801 as a single portion of a loop may also be referred to as a coil and this example may also be referred to as a vertical inductor. The inductor 802 includes three coil segments that are *seriatim* coupled to form a loop. The electrical bumps 818 may be formed by plating on the die. The bumps 818 appear to be seated on the packaging substrate 812 for illustrative convenience.

FIG. 8a is a side elevation detail of the bump inductor depicted in FIG. 8 according to an example useful for understanding the invention. The bump inductor 801 can be seen in FIG. 8 and it is represented as a single coil segment inductor. The bump inductor 801 may also be referred to as a two-bump inductor 801.

FIG. 8b is a side elevation detail of the bump inductor depicted in FIG. 8 according to an example useful for understanding the invention. The bump inductor 802 can be seen in FIG. 8 and it is represented as a triple coil segment inductor that has a tortuous current path. The bump inductor 802 may also be referred to as a four-bump inductor 802. It may now be understood that a three-bump inductor may be formed from three of the bumps depicted in FIG. 8b.

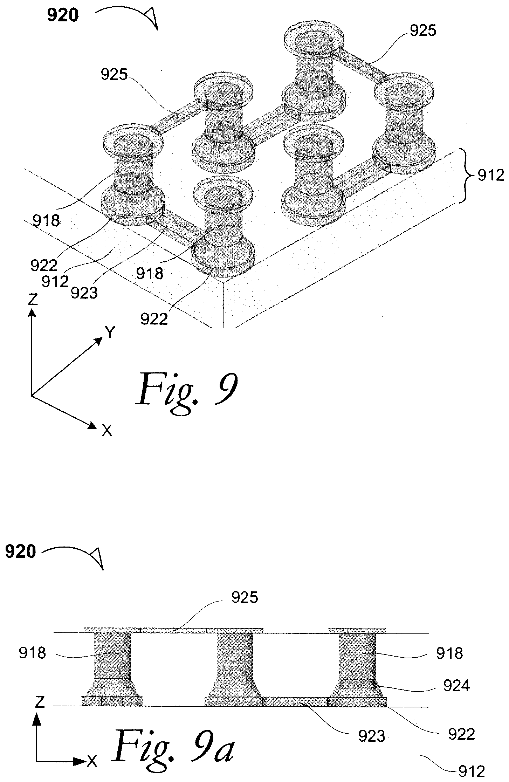

FIG. 9 is a perspective elevation wireframe of a bump inductor 920 according to an example useful for understanding the invention. The bump inductor 920 is a six-bump inductor that includes six each of electrical bumps 918, metal pads 922, conductive joints 924 that connect the electrical bumps 918 and the metal pads 922, three bottom traces 923 between metal pads 922 and two top traces 925. The inductor 920 is disposed between an SoC hybrid device example and a package substrate example 912.

FIG. 9a is a side elevation detail of the bump inductor depicted in FIG. 9 according to an example useful for understanding the invention. The six-bump inductor 920 can be seen in FIG. 9 and it is represented as a five-coil segment inductor 920 that are *seriatim* coupled to form a loop. The bump inductor 920 can be seen in FIG. 9 and it is seen that has a tortuous current path.

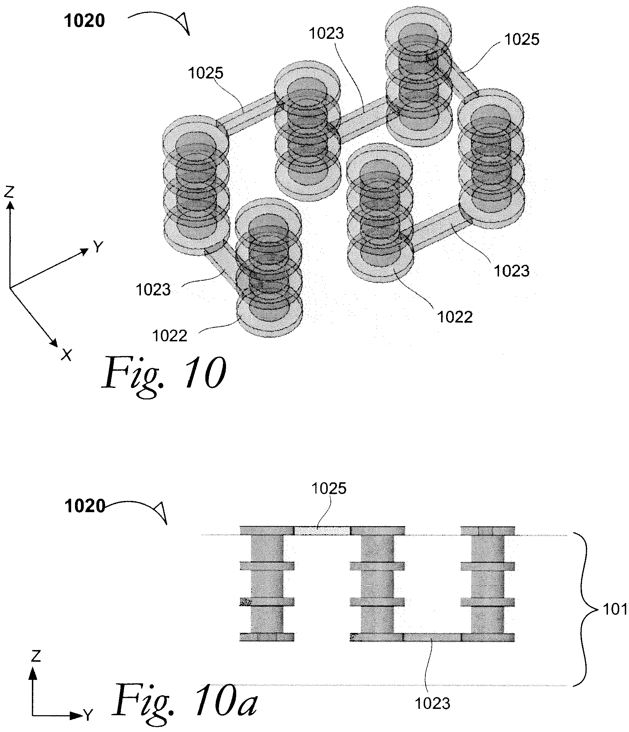

FIG. 10 is a perspective elevation wireframe of a stacked-via inductor 1020 according to an example useful for understanding the invention. The stacked-via inductor 1020 is a six-stacked-via inductor 1020 that includes six via stacks, six metal pads 1022, three bottom traces 1023 between metal pads 1022 and two top traces 1025.

FIG. 10a is a side elevation detail of the stacked-via inductor depicted in FIG. 10 according to an example useful for understanding the invention. The six-stacked-via inductor 1020 can be seen in FIG. 10 to be integral to a package substrate 1012. As seen in FIG. 10, the stacked-via inductor is represented as a five-coil segment inductor 1020 that are *seriatim* coupled to form a loop. The stacked -via inductor 1020 can be seen in FIG. 10 and it is seen that it has a tortuous current path.

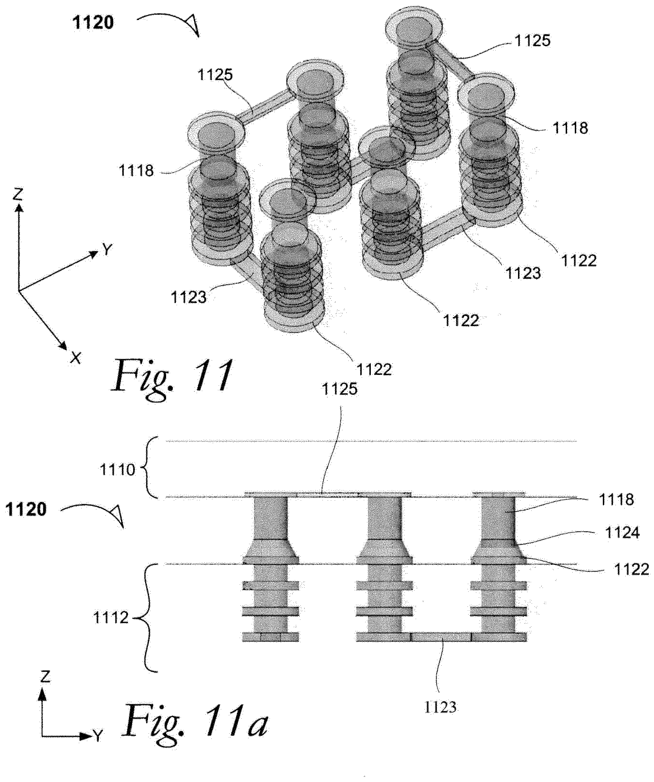

FIG. 11 is a perspective elevation wireframe of a composite bump-and-stacked-via inductor 1120 according to the embodiment. The composite bump-and-stacked-via inductor 1120 is a six-bump and six-via-stack inductor 1120 such that current flows first through a bump and into a via stack before it flows into a bottom metal pad 1122 and then into a trace 1123 according to an embodiment. From the bottom trace 1123, current then flows into an adjacent via stack and into a bump 1118. Next, current flows across a top trace 1125.

FIG. 11a is a side elevation detail of the via-stack inductor depicted in FIG. 11 according to an embodiment. The six composite-bump-and-via-stack inductor 1120 can be seen in FIG. 11 to be integral to a package substrate 1112. As seen in FIG. 11, the composite bump-and-via-stack inductor is represented as a five-coil segment inductor 1120 that are *seriatim* coupled to form a loop. The composite bump-and-via-stack inductor 1120 can be seen in FIG. 11 and it is seen that it has a tortuous current path.

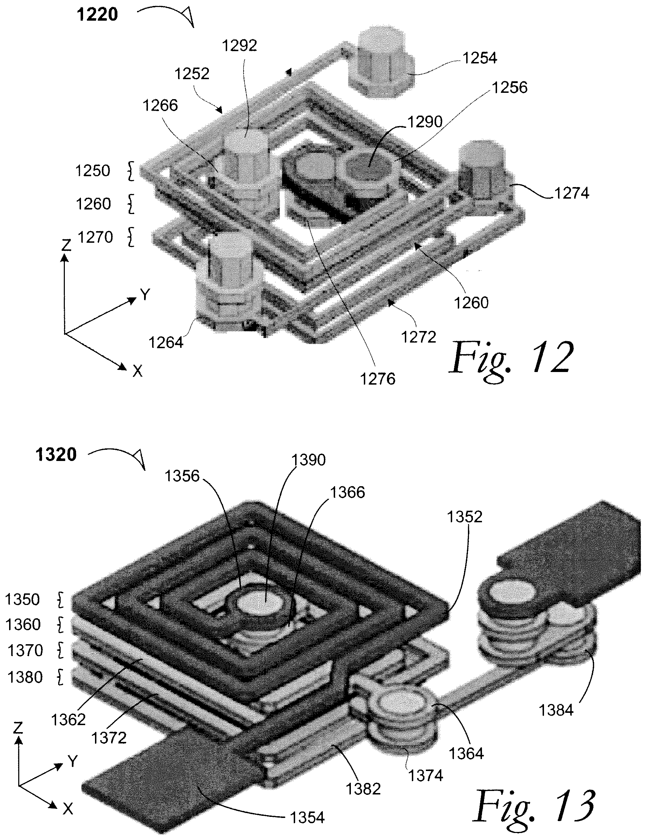

FIG. 12 is a perspective elevation of a transformer 1220 according to an example useful for understanding the invention. The transformer 1220 may be located integral to a package substrate such as any of the package substrate examples and it may be configured, e.g. as the vertical planar inductor 420 is located integral to the package substrate 412 depicted in FIG. 4 according to a non-limiting example.

The transformer 1220 includes a first inductor that includes a first coil 1252 and a third coil 1272. The first coil 1252 is located at a first level 1250 of a package substrate. For example, the package substrate 412 depicted in FIG. 4 has a first level 450. The first coil 1252 includes a first outer metal pad 1254 and a first inner metal pad 1256. A first center via 1290 is in contact with the first coil 1252 at the first level 1250 and at the first inner metal pad 1256. The first inductor also includes a third coil 1272 at a third level 1270 of the package substrate. The third coil 1272 includes a third inner metal pad 1276 that is in contact with the first center via 1290 and a third outer metal pad 1274.

The transformer 1220 includes a second inductor that includes a second coil 1262 at a second level 1260 of the package substrate. The second level 1260 is between the first level 1250 and the third level 1270. The second coil 1262 includes a second outer metal pad 1264 and a second inner metal pad 1266 in contact with a second center via 1292.

The first inductor begins at the first outer metal pad 1254 and ends at the third outer metal pad 1274. The second inductor begins at the second outer 1264 metal pad and ends at the second inner metal pad 1266. It may now be appreciated that this transformer 1220 exhibits a 2:1 transformative ratio between the first inductor and the second inductor. This transformer example 1220 may also be referred to as a folded inductor 1220 since two coils are laterally folded into each other. This transformer example 1220 may also be referred to as a three-layer, two-inductor folded transformer 1220.

In an example, the first coil 1252 and the third coil 1272 may be electrically connected in series or in parallel. When the first coil 1252 and the third coil 1272 are connected in series, the inductance is double that of the middle or second inductor. When the first coil 1252 and the third coil 1272 are connected in parallel, the inductance is half that of the middle inductor. The different connection configurations allow for different inductance ratios required for impedance matching and signal balancing.

FIG. 13 is a perspective elevation of an inductor 1320 according to an example useful for understanding the invention. The inductor 1320 may be located integral to a package substrate such as any of the package substrate examples and it may be configured, e.g. as the vertical planar inductor 420 is located integral to the package substrate 412 depicted in FIG. 4 in a non-limiting example.

The inductor 1320 includes a first coil 1352 at a first level, a second coil 1360 at a second level, a third coil 1372 at a third level 1370, and a fourth coil 1382 at a fourth level 1380.

The first coil 1352 includes a first outer metal pad 1354 and the first coil 1352 spirals inwardly to a first inner metal pad 1356. A first center via 1390 is in contact with the first coil 1352 at the first inner metal pad 1356. The inductor 1320 continues from the first coil 1352 at the center via 1390 and the center via 1390 makes contact with the second coil 1362 at a second inner metal pad 1366. The second coil 1362 spirals outwardly from the second inner metal pad 1366 to a second outer metal pad 1364. The second outer metal pad 1364 makes contact through peripheral via to a third outer metal pad 1374 of a third coil 1372 at the third level 1370 of the package substrate. The third coil 1372 includes a third inner metal pad (obscured from view) that is in contact with a center via (obscured from view) that is directly below (in the Z direction) the first center via 1390. The third coil 1372 is coupled through the obscured-from-view center via to the fourth coil 1382 at the fourth level 1380. The fourth coil 1382 spirals outwardly to a fourth outer metal pad 1384.

The inductor 1320 therefore operates with four parallel-planar spiral coils and is useful for several RF applications that support an RF section of a hybrid DP-RFIC device according to an example. The inductor 1320 may also be referred to as a four-layer single inductor 1320.

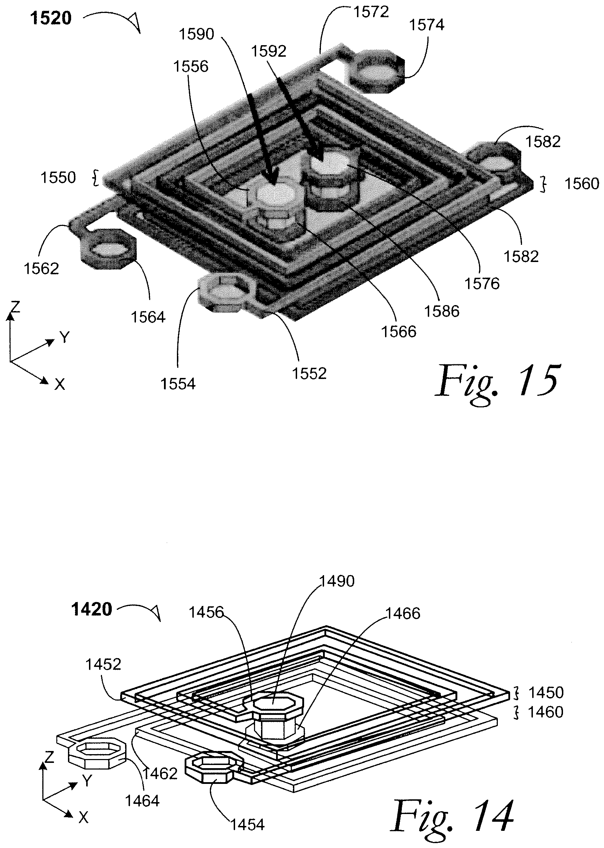

FIG. 14 is a perspective elevation of an inductor 1420 according to an example useful for understanding the invention. The inductor 1420 may be located integral to a package substrate such as any of the package substrate examples and it may be configured, *e.g.* as the vertical planar inductor 420 is located integral to the package substrate 412 depicted in FIG. 4.

The inductor 1420 includes a first coil 1452 at a first level 1450 and a second coil 1462 at a second level 1460.

The first coil 1452 includes a first outer metal pad 1454 and the first coil 1452 spirals inwardly to a first inner metal pad 1456. A first center via 1490 is in contact with the first coil 1452 at the first level 1450 and at the first inner metal pad 1456. The inductor 1420 continues from the first coil 1452 at the center via 1490 and the center via 1490 makes contact with the second coil 1462 at a second inner metal pad 1466. The second coil 1462 spirals outwardly from the second inner metal pad 1466 to a second outer metal pad 1464.

The inductor 1420 therefore operates with two parallel-planar spiral coils and is useful for several RF applications that support an RF section of a hybrid DP-RFIC device according to an example. The inductor 1420 may also be referred to as a two-layer single inductor 1420.

FIG. 15 is a perspective elevation of a transformer 1520 according to an example useful for understanding the invention. The transformer 1520 may be located integral to a package substrate such as any of the package substrate examples and it may be configured, *e.g.* as the vertical planar inductor 420 is located integral to the package substrate 412 depicted in FIG. 4 according to a non-limiting example.

The transformer 1520 includes a first inductor that includes a first coil 1552 at a first level 1550 and a second coil 1562 at a second level 1560. The first coil 1552 includes a first outer metal pad 1554 and the first coil 1552 spirals inwardly to a first inner metal pad 1556. A first center via 1590 is in contact with the first coil 1552 at the first level 1550 and at the first inner metal pad 1556. The first inductor continues from the first coil 1552 at the center via 1590 and the center via 1590 makes contact with the second coil 1562 at a second inner metal pad 1566. The second coil 1562 spirals outwardly from the second inner metal pad 1566 to a second outer metal pad 1564.

The transformer 1520 includes a second inductor that includes a third coil 1572 at the first level 1550 and a fourth coil 1582 at the second level 1560. The third coil 1572 includes a third outer metal pad 1574 and the third coil 1572 spirals inwardly to a third inner metal pad 1576. A second center via 1592 is in contact with the third coil 1572 at the first level 1550 and at the first inner metal pad 1576. The inductor 1520 continues from the third coil 1572 at the second center via 1592 and the second center via 1592 makes contact with the fourth coil 1582 at a second inner metal pad 1586. The fourth coil 1582 spirals outwardly from the fourth inner metal pad 1586 to a fourth outer metal pad 1584.

The transformer 1520 therefore operates with two folded and parallel-planar spiral inductors and is useful for several RF applications that support an RF section of a hybrid DP-RFIC device according to an example. The transformer 1520 may also be referred to as a folded, two-layer, two-inductor transformer 1520. The transformer therefore includes two planar folded inductors that are interleaved spiral structures. Each inductor has a 3D structure that is formed by folding two Marchand-type baluns according to an example. The two halves of each spiral inductor are implemented on different layers of the package substrate to enable positive electromagnetic coupling of the two inductors. A positive coupling involves rotating the bottom inductor spiral such that the direction of current flow is the same on the top and bottom halves. The electromagnetic coupling between the two halves of the same inductor enables the total inductance is greater than the sum of the individual inductor coils. In the folded inductor example, vertical electromagnetic coupling is added to lateral electromagnetic coupling. This increases the overall electromagnetic coupling coefficient between the two individual inductors.

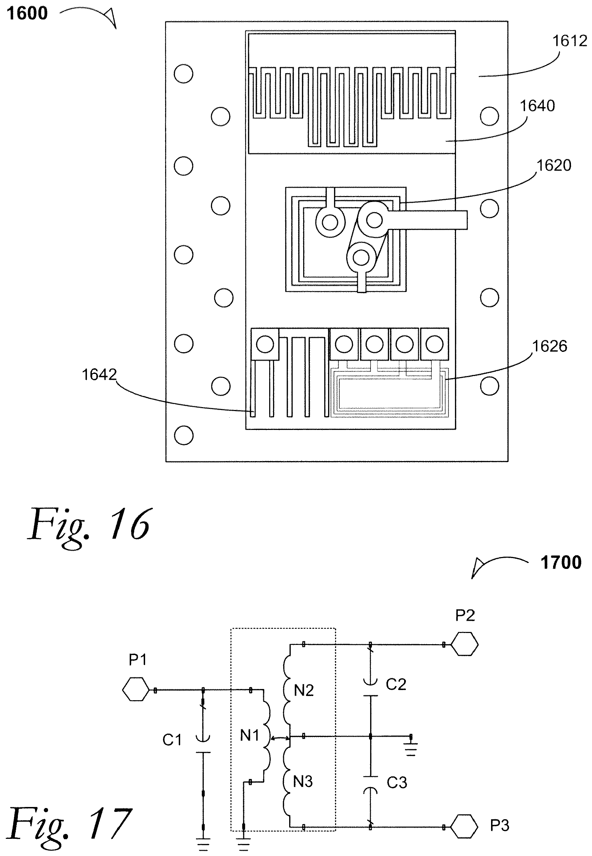

FIG. 16 is a top plan of an on-package balun 1600 that uses planar transformer examples useful for understanding the invention set forth in this disclosure. Two interdigitated capacitors 1640 and 1642 are configured on a package substrate 1612 along with one on-package balun 1620 depicted in simplified form. A parallel-plate capacitor 1626 is also depicted with four leaves that each exhibit useful shape factors. But for illustrative simplicity the form factor of each is different but would be similar in perimeter to provide substantially the same surface area between adjacent capacitor plates.

FIG. 17 is a circuit diagram 1700 of the three-capacitor, one-transformer device depicted in FIG. 16. The three capacitors are illustrated as C1, C2, and C3, which are assigned the structures 1640, 1642, and 1626, respectively, from FIG. 16. The three inductors are illustrated as N1, N2, and N3. The transformer comprises one single-ended primary inductor N1 and one center-tapped differential-ended secondary inductor N2-N3. The center tap allows the two halves of the secondary inductor N2-N3 to be electrically identical. The primary and secondary inductors are electromagnetically coupled with each other.

The circuit depicted in FIG. 17 is useful as part of a semiconductor package according to any of the disclosed semiconductor package examples and their art-recognized equivalents.

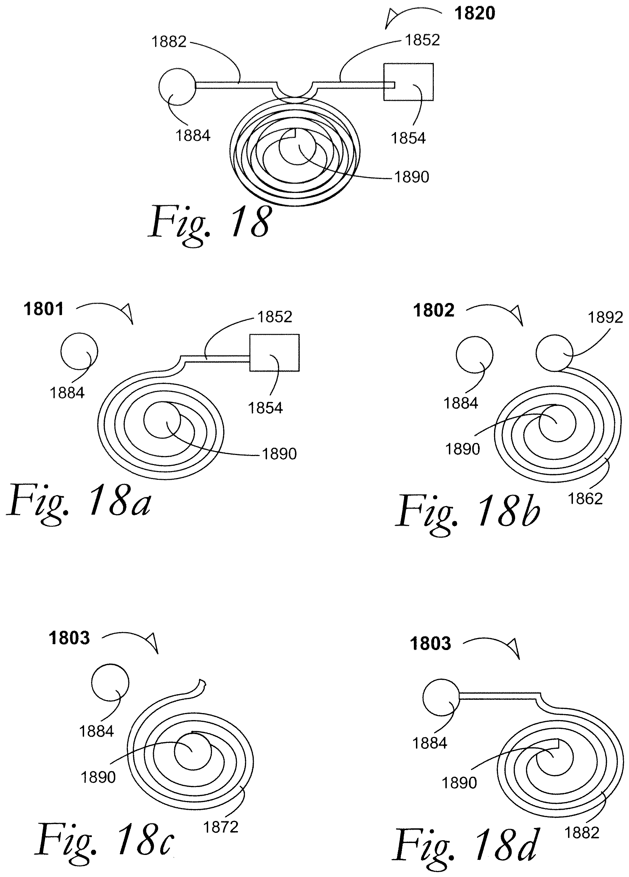

FIG. 18 is a top plan of a four-layer circular transformer 1820 according to an example useful for understanding the invention. The transformer 1820 may be located integral to a package substrate such as any of the package substrate examples and it may be configured, e.g. as the a vertical planar inductor 420 example is located integral to the package substrate 412 depicted in FIG. 4 according to an example.

The transformer 1820 includes a first coil 1852, a second coil 1862, a third coil 1872, and a fourth coil 1882. The first coil 1852 includes a first outer metal pad 1854 and the first coil 1852 spirals inwardly to a first center via 1890 that is in contact with the first coil 1852. The first center via 1890 is connected to ground to facilitate the configuration as a transformer.

FIGs. 18a, 18b, 18c, and 18d show assembly of the transformer 1820 depicted in FIG. 18. At 18a, the first coil 1852 is formed at a fourth layer and is attached to the first outer metal pad 1854. At 18b, the second coil 1862 is attached to a peripheral via 1892 and spirals inwardly in an opposite winding direction from that of the first coil 1852. At 18c, the third coil 1872 is attached to the first center via 1890 and completes a first inductor with that of the first coil 1852. It is seen the third coil 1872 is wound in the same direction as the first coil 1852. At 18d, the fourth coil 1882 is attached to a fourth outer metal pad 1884. It is seen the fourth coil 1882 is wound in the same direction as the second coil 1862. The second coil 1862 and the fourth coil 1882 complete a second inductor.

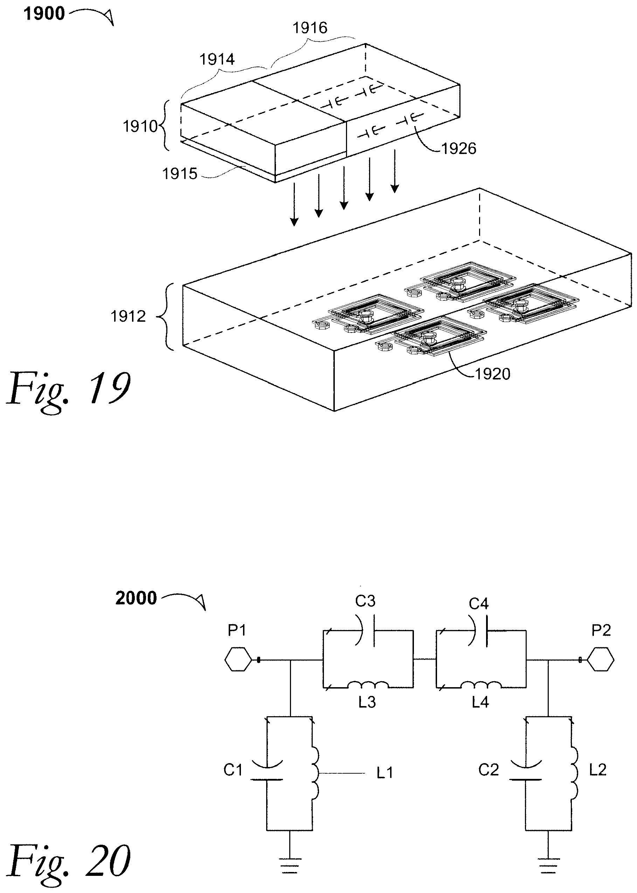

FIG. 19 is a wire-frame exploded perspective of a semiconductor package 1900 that uses a hybrid SoC 1910 and integral coils in a package substrate 1912 according to an example useful for understanding the invention. As depicted, the semiconductor package 1900 is configured as a radio frequency band-pass filter.

An SoC 1910 includes a DP-RFIC hybrid device 1910 that is disposed on the package substrate 1912. The DP-RFIC hybrid device 1910 includes a digital processor section 1914 and an RFIC section 1916. The chip apparatus 1900 is depicted in simplified form that includes DP metallization 1915 that supports the DP 1912 and RFIC metallization (not illustrated) that supports the RFIC 1916. In an example, the package substrate 1912 is a coreless substrate 1912. Electrical communication between the DP-RFIC device 1910 and the package substrate 1912 is carried out through electrical bumps according to any disclosed example or otherwise according to known technique. As illustrated, the DP-RFIC 1910 is a flip-chip 1910 that is being mated to the package substrate 1912 by use of electrical bumps.

In an example, front-end module RF passive devices are deployed between the RFIC 1916 and the package substrate 1912. As illustrated, four inductors, one of which is indicated with reference numeral 1920 are formed in the package substrate 1912. Four two-level, single-coil inductors are illustrated by way of non-limiting example. The coils 1920 may include any disclosed inductor or transformer example depending upon a given use application. As illustrated, however, the coils 1920 are inductors.

For RF-quality capacitors 1926 are depicted conceptually within the silicon of the RFIC 1916 according to an example. As a consequence of this example, a front-end module passive device, the vertical planar inductor1920s, are partitioned from- and separated out of the silicon of the RFIC 1916, which leaves more room for RF active devices within the silicon 1916. As such by partitioning and separating the passive-device inductors/transformers, larger front-end RF useful coils are used to support the RFIC 1916.

As a front-end module passive device, the RF-quality capacitors 1926, remain within the silicon of the RFIC 1916 where it may be fabricated with a high-k dielectric material for a useful capacitance and a useful small size compared to that of the inductors. In an example, the capacitors 1926 are diodes. In this example, partitioning of RF passive devices has been achieved, where the inductors 1920 are removed out of the silicon of the RFIC 1916, but capacitors and/or diodes 1926 remain in the silicon where they may be fabricated with a high-k dielectric.

FIG. 20 is a circuit diagram 2000 of the four-capacitor, four-inductor device depicted in FIG. 19. The four capacitors are illustrated as C1, C2, C3, and C4, which are assigned the structures 1926 from FIG. 19. The four inductors are illustrated as L1, L2, L3, and L4. The circuit depicted in FIG. 20 is useful as part of a semiconductor package according to any of the disclosed semiconductor package examples and their art-recognized equivalents.

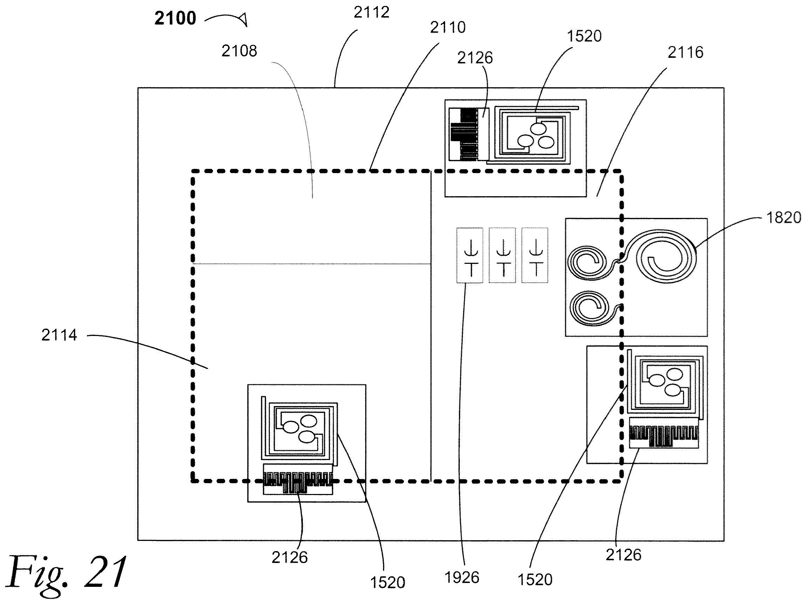

FIG. 21 is a top plan of a semiconductor package 2100 that uses a hybrid SoC 2110 (represented as a footprint in dashed outline) and integral coils in a package substrate 2112 according to an example useful for understanding the invention.

An SoC 2110 includes a DP-RFIC hybrid device 2110 that is disposed on the package substrate 2112. The DP-RFIC hybrid device 2110 includes a digital processor section 2114 and an RFIC section 2116. In an example, the SoC 2110 includes a graphics section 2108 that is adjacent the DP section 2114. The chip apparatus 2100 is depicted in simplified form and several occurrences of RF-capable on-package baluns are depicted. For example, a coiled inductor or transformer 1820 such as the structure depicted in FIG. 18 is included. A folded-coil transformer 1520 such as that depicted in FIG. 15 is also depicted along with on-package interdigital capacitors 2126.

It can be seen that the footprint of the SoC device 2110 straddles the footprints of the on-package inductors and transformers according to an example. It can also be seen that at least one high-k capacitor/diode 1926 is located within the silicon of the RFIC section 2116 of the SoC 2110.

In an example, front-end module RF passive devices are deployed between the RFIC 2116 and the package substrate 2112. As illustrated, four on-package passive-device sections are formed in the package substrate 2112.

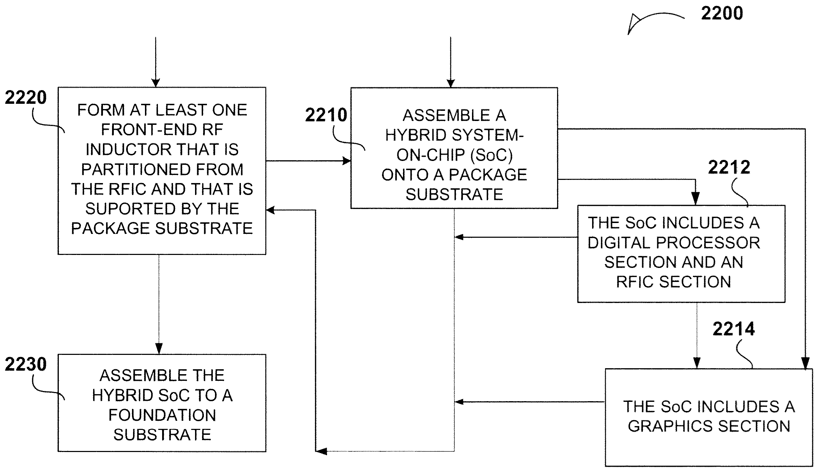

FIG. 22 is a method flow diagram 2200 according to several examples useful for understanding the invention.

At 2210, the method includes assembling an SoC hybrid electronic device to a packaging substrate.

At 2212, the method includes that the SoC is a hybrid DP-RFIC electronic device.

At 2214, the method includes that the SoC includes a graphics processor section adjacent the DP section.

At 2220, the method includes forming at least one front-end RF inductor that is supported by the package substrate. The method at 2220 also includes an example of forming at least one front-end RF transformer that is supported by the package substrate. The term "supported" means the inductor as a structure is physically touching the package substrate, if not also integral thereto. The IPDs depicted for example in FIG. 7 are not supported by the package substrate under this definition. Examples of inductor/transformer structures are set forth in this disclosure as bump inductors, stacked-via inductors, vertical planar inductors, vertical planar transformers, and combinations thereof. In an example, the method commences at 2220 in parallel with the method at 2210.

At 2230, the method includes assembling the hybrid SoC device to a foundation substrate.

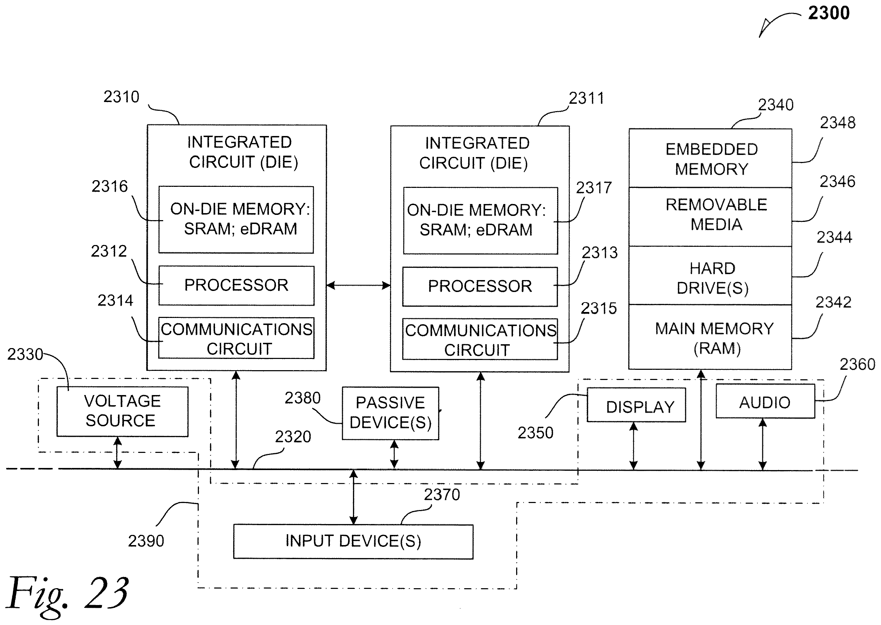

FIG. 23 is a schematic of a computing/communication system 2300 according to an example useful for understanding the invention. The computing/communication system 2300 (also referred to as the electronic system 2300) as depicted can embody a hybrid SoC device that includes DP-RFIC capabilities with partitioned front-end passive devices supported by the package substrate according to any of the several disclosed examples and their equivalents as set forth in this disclosure. The computing/communication system 2300 may be a mobile device such as a netbook computer. The computing/communication system 2300 may be a mobile device such as a wireless smart phone. The computing/communication system 2300 may be a desktop computer. The computing/communication system 2300 may be a hand-held reader. The computing/communication system 2300 may be integral to an automobile. The computer system 600 may be integral to a television.

In an example, the electronic system 2300 is a computer system that includes a system bus 2320 to electrically couple the various components of the electronic system 2300. The system bus 2320 is a single bus or any combination of busses according to various examples. The electronic system 2300 includes a voltage source 2330 that provides power to the integrated circuit 2310. In some examples, the voltage source 2330 supplies current to the integrated circuit 2310 through the system bus 2320.

The integrated circuit 2310 is electrically coupled to the system bus 2320 and includes any circuit, or combination of circuits according to an example. In an example, the integrated circuit 2310 includes a processor 2312 that can be of any type of DP example. As used herein, the processor 2312 may mean any type of circuit such as, but not limited to, a microprocessor, a microcontroller, a graphics processor, a digital signal processor, or another processor. In an example, the processor 2312 is the embedded die disclosed herein. In an example, SRAM examples are found in memory caches of the processor. Other types of circuits that can be included in the integrated circuit 2310 are a custom circuit or an application-specific integrated circuit (ASIC), such as a communications circuit 2314 for use in wireless devices such as cellular telephones, smart phones, pagers, portable computers, two-way radios, and similar electronic systems. In an example, the processor 2310 includes on-die memory 2316 such as static random-access memory (SRAM). In an example, the processor 2310 includes embedded on-die memory 2316 such as embedded dynamic random-access memory (eDRAM).

In an example, the integrated circuit 2310 is complemented with a subsequent integrated circuit 2311 such as the RF section of the DP-RFIC SoC hybrid example set forth in this disclosure.. In an example, the dual integrated circuit 2310 includes embedded on-die memory 2317 such as eDRAM. The dual integrated circuit 2311 includes an RFIC dual processor 2313 and a dual communications circuit 2315 and dual on-die memory 2317 such as SRAM. The dual communications circuit 2315 is particularly configured for RF processing.

At least one passive device 2380 is coupled to the subsequent integrated circuit 2311 such that the RFIC 2311 and the at least one passive device are part of the any hybrid SoC device that includes DP 2310 and RFIC 2311 capabilities with partitioned front-end passive devices 2380 supported by the package substrate.

In an example, the electronic system 2300 also includes an external memory 2340 that in turn may include one or more memory elements suitable to the particular application, such as a main memory 2342 in the form of RAM, one or more hard drives 2344, and/or one or more drives that handle removable media 2346, such as diskettes, compact disks (CDs), digital variable disks (DVDs), flash memory drives, and other removable media known in the art. The external memory 2340 may also be embedded memory 2348 such as an hybrid SoC device that includes DP-RFIC capabilities with partitioned front-end passive devices supported by the package substrate according to an example.

In an example, the electronic system 2300 also includes a display device 2350, and an audio output 2360. In an example, the electronic system 2300 includes an input device such as a controller 2370 that may be a keyboard, mouse, touch pad, keypad, trackball, game controller, microphone, voice-recognition device, or any other input device that inputs information into the electronic system 2300. In an example, an input device 2370 includes a camera. In an example, an input device 2370 includes a digital sound recorder. In an example, an input device 2370 includes a camera and a digital sound recorder.

A foundation substrate 2390 may be part of the computing system 2300. In an example, the foundation substrate 2390 is a motherboard that holds an inductor-containing semiconductor device substrate example. In an example, the foundation substrate 2390 is a board onto which an inductor-containing semiconductor device substrate example is mounted. In an example, the foundation substrate 2390 incorporates at least one of the functionalities encompassed within the dashed line 2390 and is a substrate such as the user shell of a wireless communicator.

As shown herein, the integrated circuit 2310 can be implemented in a number of different examples, including an hybrid SoC device that includes DP-RFIC capabilities with partitioned front-end passive devices supported by the package substrate according to any of the several disclosed examples and their equivalents, an electronic system, a computer system, one or more methods of fabricating an integrated circuit, and one or more methods of fabricating an electronic assembly that an hybrid SoC device that includes DP-RFIC capabilities with partitioned front-end passive devices supported by the package substrate according to any of the several disclosed examples as set forth herein in the various examples and their art-recognized equivalents. The elements, materials, geometries, dimensions, and sequence of operations can all be varied to suit particular I/O coupling requirements including array contact count, array contact configuration an hybrid SoC device that includes DP-RFIC capabilities with partitioned front-end passive devices supported by the package substrate according to any of the several disclosed hybrid SoC device that includes DP-RFIC capabilities with partitioned front-end passive devices supported by the package substrate examples and their equivalents.

Although a die may refer to a processor chip, an RF chip, an RFIC chip, IPD chip, or a memory chip may be mentioned in the same sentence, but it should not be construed that they are equivalent structures. Reference throughout this disclosure to "one embodiment" or "an embodiment" means that a particular feature, structure, or characteristic described in connection with the embodiment is included in at least one embodiment of the present invention. The appearance of the phrases "in one embodiment" or "in an embodiment" in various places throughout this disclosure are not necessarily all referring to the same embodiment. Furthermore, the particular features, structures, or characteristics may be combined in any suitable manner in one or more embodiments.

Terms such as "upper" and "lower" "above" and "below" may be understood by reference to the illustrated X-Z coordinates, and terms such as "adjacent" may be understood by reference to X-Y coordinates or to non-Z coordinates.

In the foregoing Detailed Description, various features are grouped together in a single embodiment for the purpose of streamlining the disclosure. This method of disclosure is not to be interpreted as reflecting an intention that the claimed embodiments of the invention require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separate preferred embodiment.
It will be readily understood to those skilled in the art that various other changes in the details, material, and arrangements of the parts and method stages which have been described and
illustrated in order to explain the nature of this invention may be made without departing from the scope of the invention as expressed in the subjoined claims.

## Claims

1. A chip apparatus (100), comprising:
a system-on-chip [SoC] electronic device (1110), including:
a semiconductive digital processor, DP, section (114) thereof;
a semiconductive radio-frequency integrated-circuit, RFIC, section (116) thereof, and where the DP section and the RFIC section form a DP-RFIC device on a semiconductive substrate; and front-end module passive devices coupled to the RFIC section; and
a package substrate (1112) upon which the DP-RFIC device is mounted, wherein at least one inductor (1120) of the front-end module passive devices is coupled to the RFIC section through the package substrate,
wherein the at least one inductor includes six electrical bump connectors (1118) between the DP-RFIC and the package substrate, wherein the at least one inductor is a single loop that includes six via stack structures, wherein said via stack structures are integral to the package substrate, wherein each via stack structure is contacted with a respective one of said six electrical bumps, to form six composite bump-and-stacked-via stacks, wherein said six composite bump-and-stacked-via stacks are seriatim coupled to form a single loop;
wherein said six composite bump-and-stacked-via stacks are coupled by five coil segment traces (1123, 1125), and wherein said five coil segment traces are provided alternatingly as three bottom traces (1123) integral with the package substrate and as two top traces (1125) integral with the system-on-chip electronic device (1110); and
a capacitor (226) within the RFIC.

2. The chip apparatus of claim 1, wherein the SoC electronic device also includes a graphics processor section disposed adjacent the semiconductive digital processor section.

3. The chip apparatus of claim 1, wherein the semiconductive substrate exhibits a resistivity in a range from 0.1 milli Ohm - cm to 1000 Ohm - cm.

## Patentansprüche

1. Eine Chipvorrichtung (100), umfassend:
eine System-on-Chip[SoC]-Elektronikeinrichtung (1110), enthaltend:
einen halbleitenden digitalen Prozessor-, DP-, Abschnitt (114) davon;
einen halbleitenden Hochfrequenz-Integrierten-Schaltungs-, RFIC-, Abschnitt (116) davon und wobei der DP-Abschnitt und der RFIC-Abschnitt eine DP-RFIC-Einrichtung auf einem halbleitenden Substrat bilden; und Frontend-Modul-Passive-Einrichtungen gekoppelt an den RFIC-Abschnitt; und
ein Packagesubstrat (1112), auf dem die DP-RFIC-Einrichtung montiert ist, wobei mindestens ein Induktor (1120) an den Frontend-Modul-Passiven-Einrichtungen durch das Package-Substrat an den RFIC-Abschnitt gekoppelt ist,
wobei
der mindestens eine Induktor sechs elektrische Höcker (1118) zwischen dem DP-RFIC und dem Packagesubstrat enthält, wobei der mindestens eine Induktor eine Einzelschleife ist, die sechs Via-Stapelstrukturen enthält, wobei die Via-Stapelstrukturen integral zu dem Packagesubstrat sind, wobei jede Via-Stapelstruktur mit einem jeweiligen der sechs elektrischen Höcker kontaktiert ist, um sechs Verbund-Höcker- und -Gestapelte-Via-Stapel zu bilden, wobei die Sechs-Verbund-Höcker- und -Gestapelte-Via-Stapel nacheinander gekoppelt sind, um eine Einzelschleife zu bilden;
wobei die sechs Verbund-Höcker- und -Gestapelte-Via-Stapel durch fünf Spulensegmentbahnen (1123, 1125) gekoppelt sind, und wobei die fünf Spulensegmentbahnen abwechselnd als drei Bodenbahnen (1123) integral mit dem Packagesubstrat und als zwei obere Bahnen (1125) integral mit der System-on-Chip-Elektronikeinrichtung (1110) bereitgestellt sind; und
einen Kondensator (226) innerhalb des RFIC.

2. Chipvorrichtung nach Anspruch 1, wobei die SoC-Elektronikeinrichtung auch einen Grafikprozessorabschnitt angeordnet bei dem halbleitenden Digitalprozessorabschnitt enthält.

3. Chipvorrichtung nach Anspruch 1, wobei das halbleitende Substrat einen spezifischen Widerstand in einem Bereich von 0,1 Milliohm-cm bis 1000 Ohm-cm aufweist.

## Revendications

1. Appareil à puce (100), comprenant :
un dispositif électronique de type système sur puce [SoC] (1110), comportant :
sa partie processeur numérique, DP, semi-conductrice (114) ;
sa partie circuit intégré radiofréquence, RFIC, semi-conductrice (116), et la partie DP et la partie RFIC formant un dispositif DP-RFIC sur un substrat semi-conducteur ; et des dispositifs passifs de module frontal couplés à la partie RFIC ; et
un substrat (1112) de boîtier sur lequel est monté le dispositif DP-RFIC, au moins une inductance (1120) des dispositifs passifs de module frontal étant couplée à la partie RFIC par l'intermédiaire du substrat de boîtier,
l'au moins une inductance comportant six connecteurs à bosse électriques (1118) entre le DP-RFIC et le substrat de boîtier, l'au moins une inductance étant une boucle simple qui comporte six structures d'empilements à vias, lesdites structures d'empilements à vias faisant partie intégrante du substrat de boîtier, chaque structure d'empilements à vias venant au contact d'une bosse respective desdites six bosses électriques pour former six empilements composites à bosses et vias empilés, lesdits six empilements composites à bosses et vias empilés étant couplés l'un à la suite de l'autre pour former une boucle simple ;
lesdits empilements composites à bosses et vias empilés étant couplés par cinq traces de segment de bobine (1123, 1125), et lesdites cinq traces de segment de bobine étant disposées en alternance sous forme de trois traces inférieures (1123) faisant partie intégrante du substrat de boîtier et sous forme de deux traces supérieures (1125) faisant partie intégrante du dispositif électronique de type système sur puce (1110) ; et
un condensateur (226) à l'intérieur du RFIC.

2. Appareil à puce selon la revendication 1, dans lequel le dispositif électronique de type SoC comporte également une partie processeur graphique adjacente à la partie processeur numérique semi-conductrice.

3. Appareil à puce selon la revendication 1, dans lequel le substrat semi-conducteur présente une résistivité dans une plage de 0,1 milliohm - cm à 1000 ohms - cm.
